# EUROPEAN PATENT APPLICATION

(11) **EP 2 508 337 A1**
(43) Date of publication of application: **10.10.2012**
(21) Application number: 11160658.8
(22) Date of filing: 31.03.2011
(51) Int. Cl.: B32B 5/26, D03D 15/00, H05K 1/00

(54) **Conductive fabric and method for forming the same**

(71) Applicant: Tex-Ray Industrial Co., Ltd., Taipei City (TW); King's Metal Fiber Technologies Co., Ltd., Taipei City (TW)
(72) Inventor: Lee, James, Taipei City (TW); Huang, Hong Hsu, Taipei (TW)
(74) Representative: Viering, Jentschura & Partner

(57) **Abstract**

A conductive fabric and a method for forming the same are provided. The conductive fabric comprises a first layer and a second layer. The first layer has at least one first conductive thread and a plurality of first non-conductive threads. The at least one first conductive thread is woven within the plurality of first non-conductive threads. The second layer has at least one second conductive thread and a plurality of second non-conductive threads. The at least one second conductive thread is woven within the plurality of second non-conductive threads. The first layer is woven with the second layer and insulated from the second layer so that an electronic component can be attached to and electrically connect to the at least one first conductive thread of the first layer and the at least one second conductive thread of the second layer.

## Description

### CROSS-REFERENCES TO RELATED APPLICATIONS

Not applicable.

### BACKGROUND OF THE INVENTION

### Field of the Invention

The present invention relates to a conductive fabric and a method for forming the same. More particularly, the present invention relates to a layered conductive fabric and a method for forming the same.

### Descriptions of the Related Art

Fabrics in modern life are mostly used for being woven into normal clothing. Those fabrics have no additional function except for keeping warm and pursuing fashion. Recently, with the rapid growth of technology, more functions of the fabrics have been developed to increase the convenience of human life. For example, some of the fabrics are formed with some electronic components being attached thereon. Therefore, the clothing made of those fabrics with electronic components can be applied to many new fields. For example, LED lights can be used as indicators on the clothing for showing other people the ongoing direction or other applications.

However, it is complicated to attach the electronic components to the fabrics and detrimental to mass production accordingly. Moreover, one of the most important issues for those fabrics with electronic components attached thereon is to develop appropriate structures for insulation. Specifically, the fabrics must be conductive for those electronic components. Therefore, if the circuits are not insulted completely, those electronic components would be easily short with the human body and result in injury to the one who wear the clothing made of those fabrics. Accordingly, a better structure and manufacturing method for conductive fabrics is essentially needed.

### SUMMARY OF THE INVENTION

For solving above problems, this invention provides a conductive fabric and a method for forming the same. On account of a layered structure of the conductive fabric, the circuits of the fabrics can work well without causing any short circuit so that an electrical component can be attached onto it and be enabled as well.

The primary objective of this invention is to provide a conductive fabric. The conductive fabric comprises a first layer and a second layer. The first layer has at least one first conductive thread and a plurality of first non-conductive threads. The at least one first conductive thread is woven within the plurality of first non-conductive threads. The second layer has at least one second conductive thread and a plurality of second non-conductive threads. The at least one second conductive thread is woven within the plurality of second non-conductive threads. The first layer is woven with the second layer and insulated from the second layer so that an electronic component can be attached to and electrically connect to the at least one first conductive thread of the first layer and the at least one second conductive thread of the second layer.

Another objective of this invention is to provide a method for forming a conductive fabric. The method comprises the following steps: weaving at least one first conductive thread within a plurality of first non-conductive threads to form a first layer with at least one first cored yarn; weaving at least one second conductive thread within a plurality of second non-conductive threads to form a second layer with at least one second cored yarn; and weaving the first layer and the second layer with a plurality of third non-conductive threads.

Yet a further objective of this invention is to provide a fabric circuit. The fabric circuit comprises at least one electronic component and a conductive fabric. The conductive fabric comprises a first layer and a second layer. The first layer has at least one first conductive thread and a plurality of first non-conductive threads, wherein the at least one first conductive thread is woven within the plurality of first non-conductive threads. The second layer has at least one second conductive thread and a plurality of second non-conductive threads. The at least one second conductive thread is woven within the plurality of second non-conductive threads. The first layer is woven with the second layer and insulated from the second layer so that an electronic component can be attached to and electrically connect to the at least one first conductive thread of the first layer and the at least one second conductive thread of the second layer. The at least one electronic component is attached to the conductive fabric and electrically connects to the at least one first conductive thread and the at least one second conductive thread.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIG 1A** is a schematic view of a first embodiment of the present invention;
**FIG. 1B** is a schematic view of a first layer of the present invention;
**FIG 1C** is a schematic view of a second layer of the present invention;
**FIG 1D** is a cross-section view of the first layer from A to A' in **FIG. 1B****;**
**FIG 1E** is a cross-section view of the second layer from B to B' in **FIG. 1C****;**
**FIG. 1F** is a cross-section view of a fabric circuit **1** from A to A' in **FIG. 1A****;**
**FIG 1G** is a cross-section view of the fabric circuit from B to B' in **FIG. 1A****;**
**FIG. 2A** is a schematic view of a second embodiment of the present invention;
**FIG. 2B** is a cross-section view of a fabric circuit **1'** from C to C' in **FIG. 2A****;**
**FIG 3A** is a schematic view of a third embodiment of the present invention;
**FIG. 3B** is a schematic view of a fourth embodiment of the present invention;
**FIG. 4** is a schematic view of a fifth embodiment of the present invention; and
**FIG. 5** is a flowchart of a sixth embodiment of the present invention.

### DESCRIPTION OF THE PREFERRED EMBODIMENT

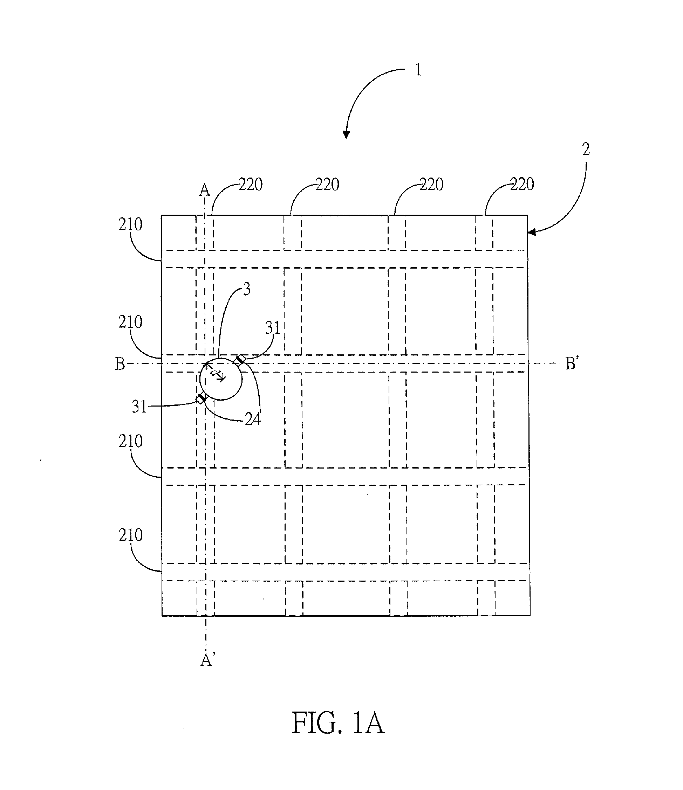

Referring to **FIG. 1A****,** it shows a fabric circuit **1** of a first embodiment of the present invention. The fabric circuit **1** can be integrated into one portion of any conventional fabrics or cloth to broaden the original functions thereof. Specifically, the fabric circuit **1** comprises a conductive fabric **2** and at least one electrical component **3** attached on the conductive fabric **2.** The conductive fabric **2** of this invention basically is a fabric capable of electrically connecting with any electrical component, such as light emitting diodes (LEDs), chips, or the like.

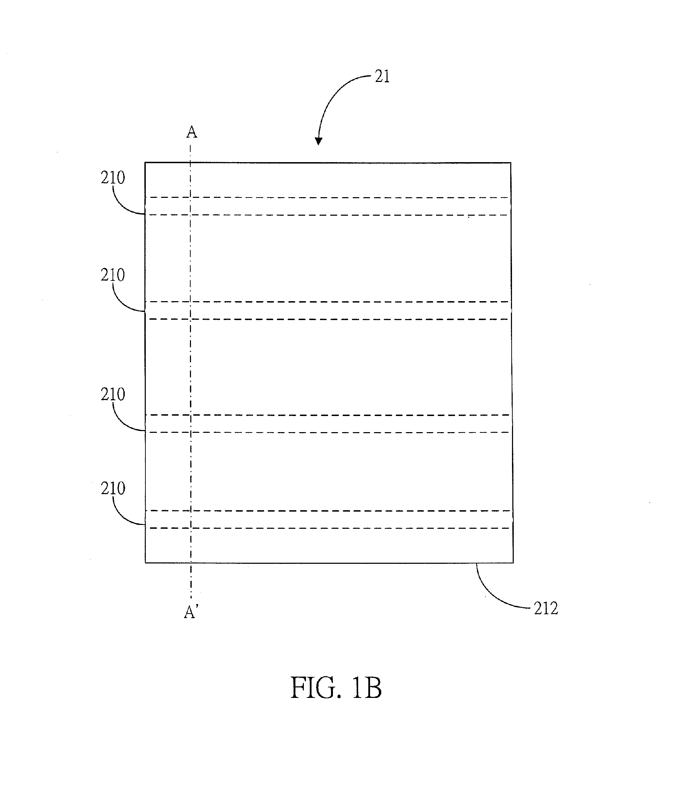

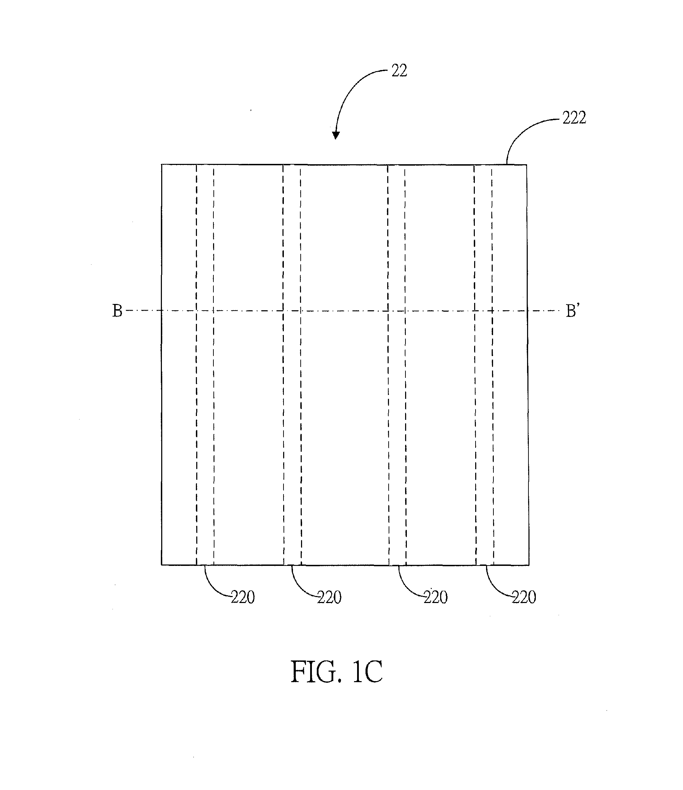

Please then refer to **FIG. 1B** and **FIG. 1C** simultaneously. The conductive fabric **2** comprises a first layer **21** and a second layer **22.** The first layer **21** has, for example, but not limited to, four first conductive threads **210** and a plurality of first non-conductive threads **212.** The first conductive threads **210** are flexible and woven within the first non-conductive threads **212.** Similarly, the second layer **22** has, for example, but not limited to, four second conductive threads **220** and a plurality of second non-conductive threads **222.** The second conductive threads **220** are flexible and woven within the second non-conductive threads **222.**

It should be noted that the first conductive threads **210** and the second conductive threads **220** are made of any conductive fibers with electric conductivity, for example, but not limited to, stainless steel fibers, carbon fibers, sputtered silver, or their combinations. Moreover, the first conductive threads **210** and the second conductive threads **220** are flexible enough for be woven with any conventional fabrics or cloth. Further, the first non-conductive threads **212** of the first layer **21** and the second non-conductive threads **222** of the second layer **22** are all made of any non-conductive materials, for example, polyester, PET, cotton, pure polyurethane polymer, or their combinations.

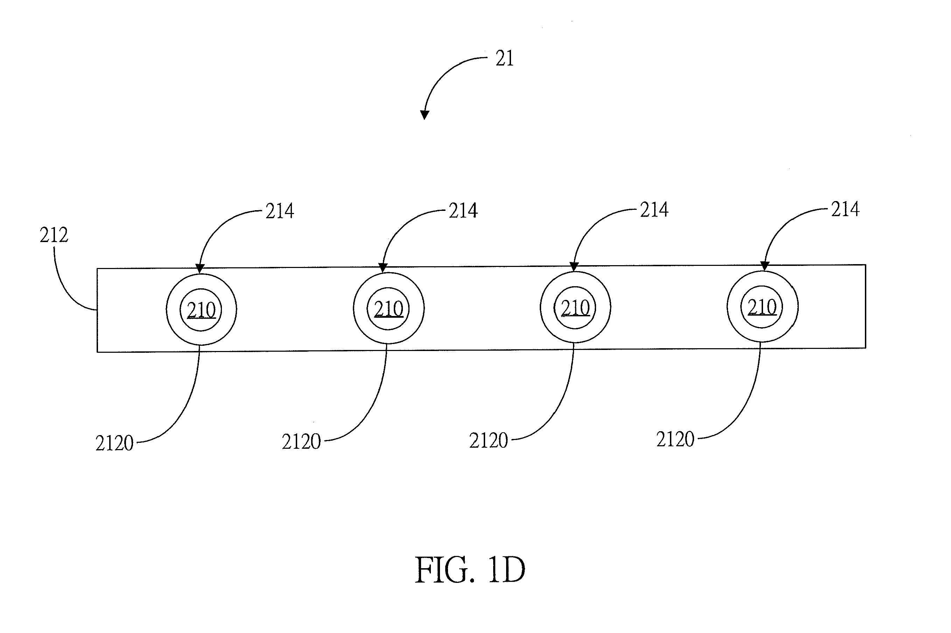

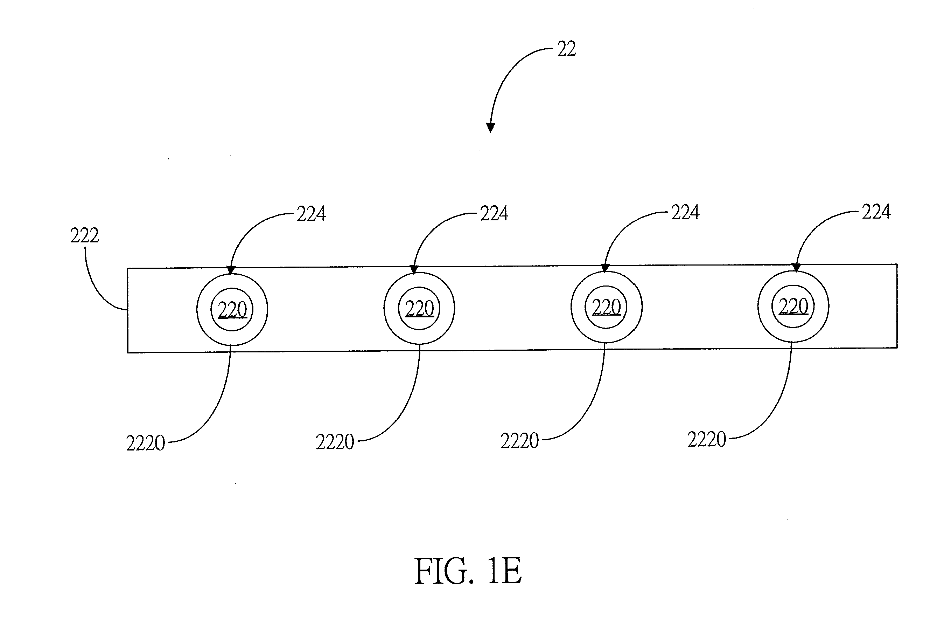

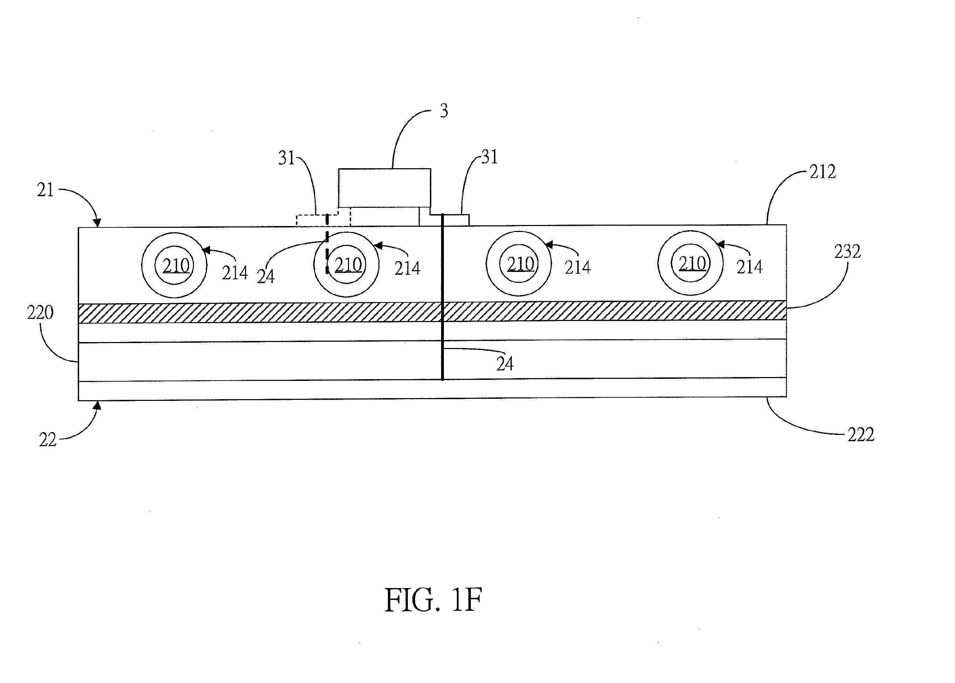

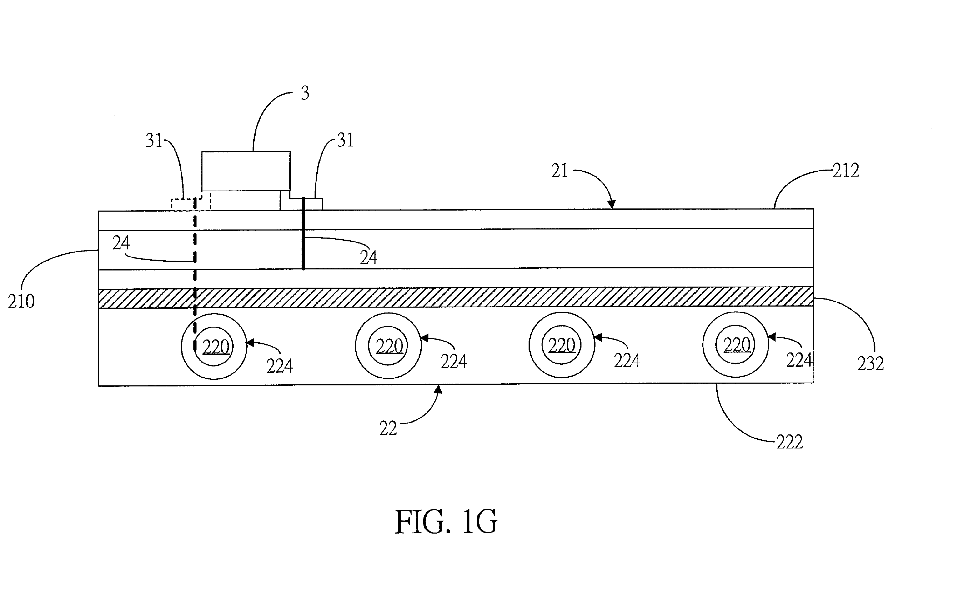

More details of the first layer **21** are shown in **FIG 1D** which is a cross-section view of the first layer **21** from A to A' in **FIG 1****B.** It can be seen clearly that the first non-conductive threads **212** are formed in a layered structure. Preferably, one portion of the first non-conductive threads **212** comprises a plurality of first covering portions **2120.** In this embodiment, four first covering portions **2120** existed in the layered structure and each of the first conductive threads **210** is covered by the corresponding first covering portion **2120** to form a first cored yarn **214.** Then, the first cored yarns **214** would be used to be woven with another portion of the first non-conductive threads **212** together to form the first layer **21.** It is noted that the cored yarn is a basic conductive unit of the conductive fabric with a good insulation property, and specially, the cored yarn is flexible and could be easily wound around a shuttle so that the cord yarn could be easily adopted in any conventional textile machinery.

Similarly, **FIG. 1E** is the cross-section view of the second layer **22** from B to B' in **FIG 1C****.** **FIG. 1E** illustrates the details of the second layer **22** just the same as the details of the first layer **21.** The second non-conductive threads **222** are formed in a layer structure as well and one portion of the second non-conductive threads **222** comprise four second covering portions **2220** covering the four second conductive threads **220** respectively and form four second cored yarn **224** existed therein. Then, the second cored yarns **224** would be used to be woven with another portion of the second non-conductive threads **222** together to form the second layer **22.**

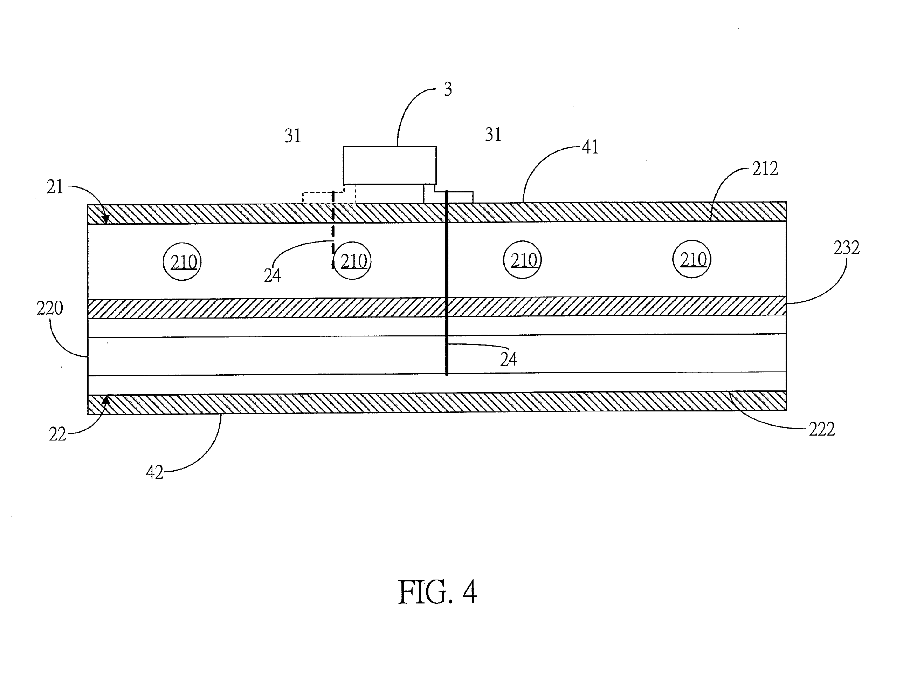

As described above, the first and the second conductive threads **210, 220** are woven or knit within the first and the second non-conductive threads **212, 222** to form the first layer **21** and the second layer **22** respectively. Moreover, other manufacturing methods would be applied to form the layered structure, such as embroidery or printing, or the like. Furthermore, the first layer **21** could be woven or embroidery with the second layer **22** together to form the fabric circuit **1** wherein the first layer **21** is insulated from the second layer **22.** To enhance the insulation between the fabric circuit **1** with the human body, the conductive fabric **2** can further comprise at least one insulation layer for covering one of the first layer **21** and the second layer **22.** As the preferred embodiment shown in **FIG. 4****,** there are two insulation layers **41, 42** for covering the first layer **21** and the second layer **22** individually. The insulation layer could be coated or printed or adhesive to the first and the second layers **21, 22** by any non-conductive material. More details will be described in the following. In a preferred embodiment, the conductive fabric **2** further comprises a plurality of third non-conductive threads **232** for weaving the first layer **21** and the second layer **22** together and insulating therebetween, as shown in **FIG 1F** and **FIG. 1G** which are the cross-section views of the fabric circuit **1** in **FIG 1A****.** Particularly, the third non-conductive threads **232** could be formed as a layered structure between the first layer **21** and the second layer **22.** The third non-conductive threads **232** are made of any non-conductive material, for example, polyester, PET, cotton, pure polyurethane polymer, or their combinations, so that the first layer **21** would be completely insulated from the second layer **22.**

Furthermore, in this embodiment, the first layer **21** and the second layer **22** are woven together as mentioned above while the first cored yarns **214** and the second cored yarns **224** in the conductive fabric **2** are configured in warps and wefts form as shown in **FIG 1A****.** Therefore, there are many junctions formed by intersecting the first cored yarns **214** and the second cored yarns **224.** The junctions distributed on the conductive fabric **2** are arranged in a matrix or an array or any other configurations.

Please refer to **FIGs. 1A****,** **1F** and **1G** illustrating a top view and two cross-section views of the fabric circuit **1.** The electronic component **3** can be attached to a position adjacent to any junction of the fabric circuit **1.** Specifically, the electronic component **3** has two leads **31** which are used for being attached onto the conductive fabric **2.** Particularly, two conductive sewing threads **24** are used for sewing the leads **31** of the electronic component **3** onto one position which has a small offset d with a specific junction of the conductive fabric **2,** and each of the leads **31** of the electronic component **3** electrically connects to one of the first conductive threads **210** and one of the second conductive threads **220** respectively near the junction. Similarly, the conductive sewing threads **24** are made of any conductive fibers with electric conductivity, for example, but not limited to, stainless steel fibers, carbon fibers, sputtered silver, or their combinations. Similar with sewing buttons onto cloth, the electronic component **3** could be sewn onto the conductive fabric **2** by any conventional sewing machine. Therefore, both the conductive fabric **2** and the fabric circuit **1** can be manufactured by any conventional textile machinery and/or sewing machine in a mass production manner. The electronic component **3** can be detachably attached to and electrically connect to one of the first conductive threads **210** of the first layer **21** and one of the second conductive threads **220** of the second layer **22** systematically, and the electronic component **3** can function well when the first conductive threads **210** and the second conductive threads **220** are electrically connected to the power system (not shown). Moreover, when the fabric circuit **1** is arranged in a matrix circuit, the electronic components **3,** such as LEDs, can be driven by any conventional control code for different specific applications, such as entertainments, indicating, signaling. It should be noted that the sewing threads **24** can electrically connect the first and the second conductive threads **210, 220** with the leads of the electronic component **3** directly driven by the sewing machine needle puncturing through the first layer **21** and the second layer **22** several times.

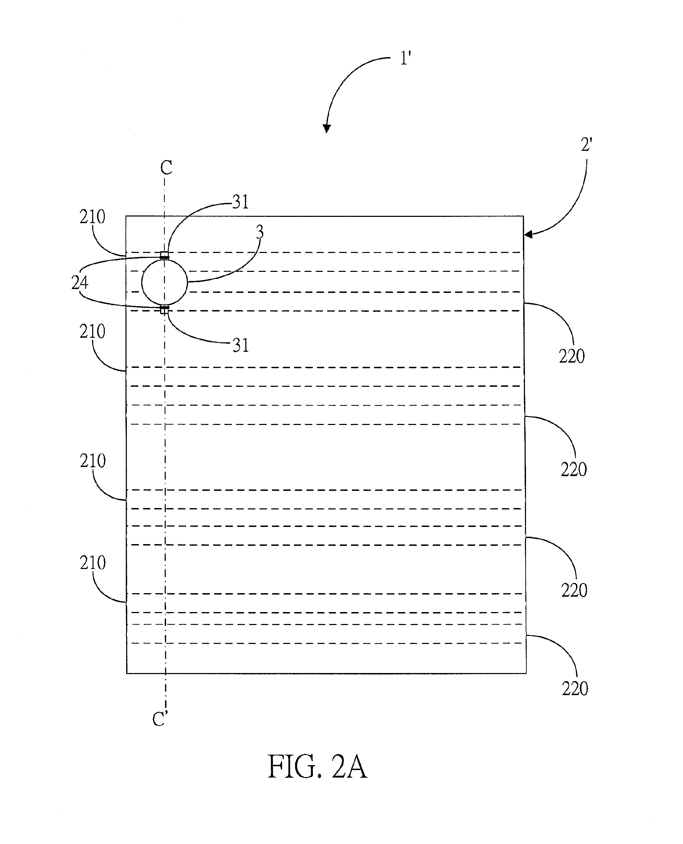

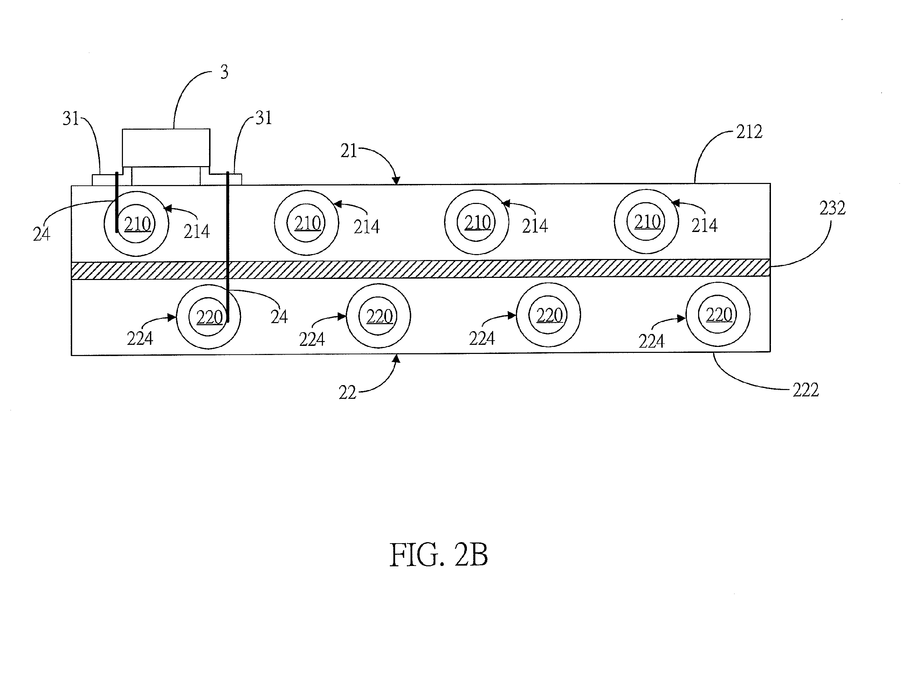

**FIG 2A** and **FIG. 2B** illustrate a fabric circuit **1'** of a second embodiment. In this embodiment, the first cored yarns **214** of the first layer **21** and the second cored yarns **224** of the second layer **22** are woven in parallel. The other features of the fabric circuit **1'** are similar with those of the fabric circuit **1.** Hence, the details of the structure of the fabric circuit **1'** will not be further described.

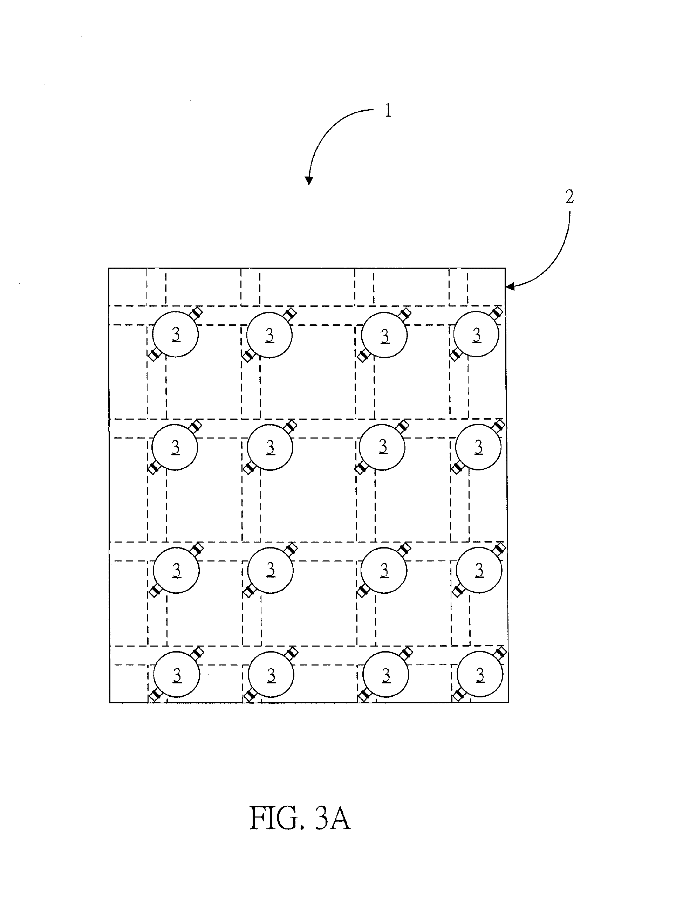

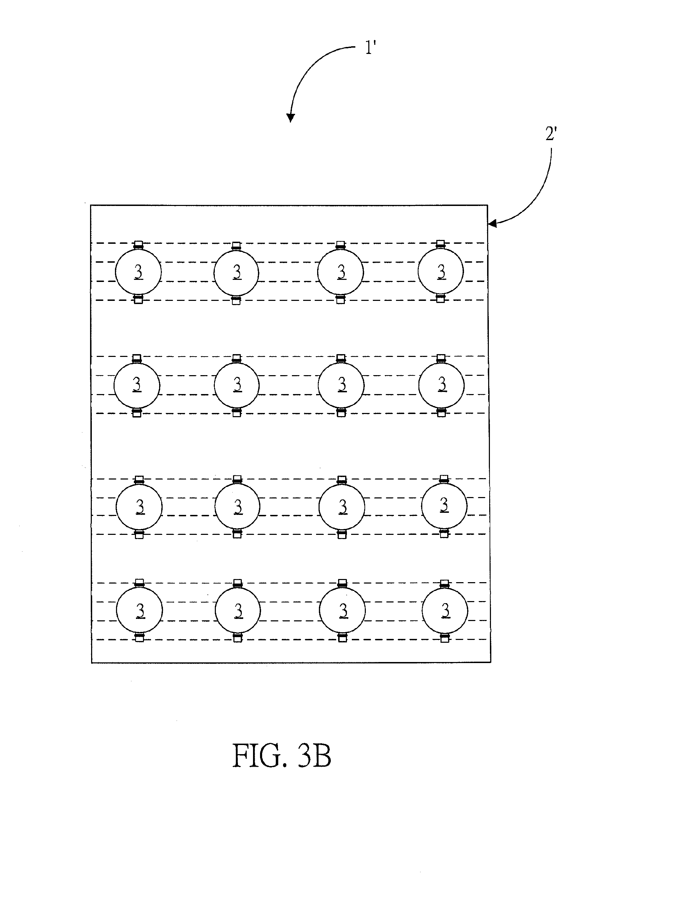

Based on the above-mentioned, another two fabric matrixes can be accomplished. Please refer to **FIG. 3A** and **FIG 3B****,** illustrating a third embodiment and a fourth embodiment of this invention respectively. A plurality of electronic components **3** are attached to each position adjacent to the junction of the fabric circuit **1** and the fabric circuit **1'.** In real embodiments, if the electronic components **3** comprise several LEDs, the different lighting patterns on the fabric circuit **1** and the fabric circuit **1'** can be accomplished.

A fifth embodiment of present invention is illustrated in FIG. **4****.** The conductive fabric **2** comprises two insulation layers **41, 42** for covering the first layer **21** and the second layer **22** individually. The other elements are the same with those described in the aforesaid. The two insulation layers **41, 42** are used to enhance the insulation between the fabric circuit **1** and the human body. The other details of this embodiment are similar with the abovementioned.

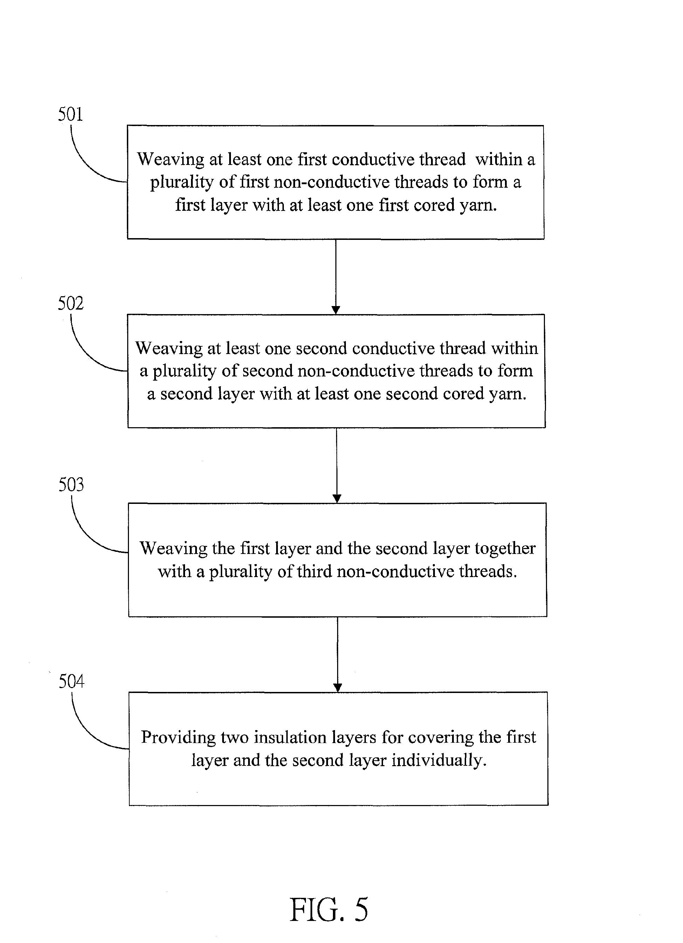

A sixth embodiment of the present invention is a method for forming a conductive fabric which is similar to the conductive fabrics **2, 2'** as described above. Referring to **FIG. 5****,** it a flowchart of the method of the present invention. At first, in step **501,** at least one first conductive thread is woven within a plurality of first non-conductive threads to form a first layer with at least one first cored yarn. Particularly, some of the first non-conductive threads are used for covering the at least one first conductive thread to form the at least one first cored yarn. And if there is more than one first cored yarn, rests of the first non-conductive threads are then used for weaving the first cored yarns together. Then, in step **502,** at least one second conductive thread is woven within a plurality of second non-conductive threads to form a second layer with at least one second cored yarn. Similarly, some of the second non-conductive threads are used for covering the at least one second conductive thread to form the at least one second cored yarn. If there is more than one second cored yarn, rests of the second non-conductive threads are then used for weaving the second cored yarns together.

In step **503,** the first layer and the second layer are woven together with a plurality of third non-conductive threads. Specifically, the third non-conductive threads are woven into a layer between the first layer and the second layer, and then weaving the first layer and the second layer together at the same time. Finally, step **504** is optionally for providing two insulation layers for covering the first layer and the second layer individually. Similar to the third non-conductive threads which are used for insulating and weaving the first layer and the second layer, the two insulation layers can be woven onto the first layer and the second layer respectively.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. A conductive fabric, comprising:
a first layer, having at least one first conductive thread and a plurality of first non-conductive threads, wherein the at least one first conductive thread is woven within the plurality of first non-conductive threads; and
a second layer, having at least one second conductive thread and a plurality of second non-conductive threads, wherein the at least one second conductive thread is woven within the plurality of second non-conductive threads;
wherein the first layer is woven with the second layer and insulated from the second layer so that an electronic component can be attached to and electrically connect to the at least one first conductive thread of the first layer and the at least one second conductive thread of the second layer respectively.

2. The conductive fabric as claimed in claim 1, wherein the first non-conductive threads comprise a first covering portion, the at least one first conductive thread is covered by the first covering portion to form at least one first cored yarn, the second non-conductive threads comprise a second covering portion, and the at least one second conductive thread is covered by the second covering portion to form at least one second cored yarn.

3. The conductive fabric as claimed in claim 2, wherein the at least one first cored yarn of the first layer and the at least one second cored yarn of the second layer are woven into warps and wefts.

4. The conductive fabric as claimed in claim 2, wherein the at least one first cored yarn of the first layer and the at least one second cored yarn of the second layer are woven in parallel.

5. The conductive fabric as claimed in claim 2, further comprising a plurality of third non-conductive threads for weaving the first layer and the second layer together.

6. The conductive fabric as claimed in claim 5, wherein the first non-conductive threads, the second non-conductive threads and the thirds threads are made by a group consisted of polyester, PET, cotton, pure polyurethane polymer and their combinations.

7. The conductive fabric as claimed in claim 1, further comprising at least one insulation layer for covering one of the first layer and the second layer.

8. The conductive fabric as claimed in claim 1, wherein the at least one first conductive thread and the at least one second conductive thread are made by conductive fibers with electric conductivity.

9. The conductive fabric as claimed in claim 8, wherein the conductive fibers are made by a group consisted of stainless steel fibers, carbon fibers, sputtered silver and their combinations.

10. A method for forming a conductive fabric, comprising the following steps:
weaving at least one first conductive thread within a plurality of first non-conductive threads to form a first layer with at least one first cored yarn;
weaving at least one second conductive thread within a plurality of second non-conductive threads to form a second layer with at least one second cored yarn; and
weaving the first layer and the second layer with a plurality of third non-conductive threads.

11. The method as claimed in claim 10, further comprising one step of providing at least one insulation layer for covering one of the first and the second layer.

12. A fabric circuit, comprising:
at least one electronic component; and
a conductive fabric, comprising:
a first layer, having at least one first conductive thread and a plurality of first non-conductive threads, wherein the at least one first conductive thread is woven within the plurality of first non-conductive threads; and
a second layer, having at least one second conductive thread and a plurality of second non-conductive threads, wherein the at least one second conductive thread is woven within the plurality of second non-conductive threads;
wherein the first layer is woven with the second layer and insulated from the second layer so that the at least one electronic component is attached to the conductive fabric and electrically connects to the at least one first conductive thread and the at least one second conductive thread.

13. The fabric circuit as claimed in claim 12, further comprising at least one conductive sewing thread, wherein each of the at least one electronic component has at least two leads for being sewed onto the conductive fabric by the at least one conductive sewing thread and each of the at least two leads of the electronic component electrically connects to the at least one first conductive thread and the at least one second conductive thread respectively.

14. The fabric circuit as claimed in claim 13, wherein the at least one electronic component is a light emitting diode, wherein the light emitting diode has two leads for being sewed onto the conductive fabric by the at least one conductive sewing thread and each of the two leads of the light emitting diode electrically connects to the at least one first conductive thread and the at least one second conductive thread respectively.

15. The fabric circuit as claimed in claim 12, wherein the first non-conductive threads comprise a first covering portion and the second non-conductive threads comprise a second covering portion, the at least one first conductive thread is covered by the first covering portion to form at least one first cored yarn and the at least one second conductive thread is covered by the second covering portion to form at least one second cored yarn.

16. The fabric circuit as claimed in claim 15, wherein the at least one first cored yarn of the first layer and the at least one second cored yarn of the second layer are woven into warps and wefts, and the at least one electronic component are attached to a position adjacent to a junction formed by the at least one first cored yarn intersecting the at least one second cored yarn.
